# EUROPEAN PATENT APPLICATION

(11) **EP 4 625 484 A1**
(43) Date of publication of application: **01.10.2025**
(21) Application number: 24167538.8
(22) Date of filing: 28.03.2024
(51) Int. Cl.: H01L 21/822, H01L 21/8234, H01L 27/06, H01L 29/06, H01L 29/417, H01L 29/66, H01L 29/775, H01L 29/786, H01L 21/8238, H01L 27/092

(54) **CFET STRUCTURE AND METHOD OF FABRICATING A CFET STRUCTURE**

(71) Applicant: Imec VZW, 3001 Leuven (BE)
(72) Inventor: Mirabelli, Gioele, 3000 Leuven (BE); Ryckaert, Julien, 1030 Schaerbeek (BE); Boemmels, Juergen, 3001 Heverlee (BE)
(74) Representative: Roth, Sebastian

(57) **Abstract**

The disclosure relates to a complementary field effect transistor, CFET, structure (1). The CFET structure (1) comprises: a first CFET element (10) which is arranged in a first row of the CFET structure (1); and a second CFET element (10') which is arranged in a second row of the CFET structure (1), wherein the second row is arranged laterally offset to the first row; wherein the first and the second CFET element (10') each comprise: a first transistor structure (21), and a second transistor structure (22) which is arranged above the first transistor structure (21). The CFET structure (1) further comprises a shared signal routing structure (16) which is arranged between the first and the second CFET element (10, 10'); wherein the shared signal routing structure (16) is electrically connected to the first and/or the second transistor structure (21, 22) of the first and/or of the second CFET element (10, 10'), respectively.

## Description

### TECHNICAL FIELD

The present disclosure refers to a complementary field effect transistor (CFET) structure and to a method of fabricating such a CFET structure.

### BACKGROUND

In a CFET device, different transistor structures, particularly NMOS and PMOS transistors, may be stacked on top of each other compared, for example, to a nanosheet device, which comprises NMOS and PMOS transistors arranged side by side with a spacing in between them. The stacking of the transistor structures in the CFET device enables increasing an effective channel width.

An issue in conventional CFET devices is related to the power supply of the stacked transistor structures and to the signaling between them. The electrical power for the top and bottom transistor of the CFET can be provided from a backside power delivery network (BSPDN), which is arranged below the CFET device. However, connecting a stacked top and bottom transistor structures to the BSPDN and at the same time connecting the stacked structures to each other for exchanging signals is difficult to realize.

Furthermore, the signal and power lines required for such connections can take up a lot of space which causes an area penalty. Some conventional CFET architectures use deep vias for signal routing and power connections which can be challenging to process, especially in case of tight tip-to-tip (T2T) cell boundary scaling.

### SUMMARY

Thus, it is an objective to provide an improved CFET structure and an improved method of fabricating a CFET structure. In particular, the above-mentioned disadvantages should be avoided.

The objective is achieved by the embodiments provided in the enclosed independent claims. Advantageous implementations of the embodiments of the disclosure are further defined in the dependent claims.

A first aspect of this disclosure provides a complementary field effect transistor (CFET) structure. The CFET structure comprises: a first CFET element which is arranged in a first row of the CFET structure; and a second CFET element which is arranged in a second row of the CFET structure, wherein the second row is arranged laterally offset to the first row; and wherein the first and the second CFET element each comprise: a first transistor structure, and a second transistor structure which is arranged above the first transistor structure. The CFET structure further comprises a shared signal routing structure which is arranged between the first and the second CFET element; wherein the shared signal routing structure is electrically connected to the first and/or the second transistor structure of the first and/or of the second CFET element, respectively.

This achieves the advantage that a more compact CFET structure can be achieved, as two adjacent rows (i.e., two adjacent transistor stacks) of the CFET structure can share a single signal routing structure.

The first transistor structures can be respective bottom transistor structures and the second transistor structures can be respective top transistor structures. For example, the first (or bottom) transistor structures are arranged in a first tier (or level) and the second (or top) transistor structures are arranged in a second tier (or level) of the CFET structure, wherein the second tier is arranged above the first tier. This may result in stacked transistor structures of the CFET structure. The first and second transistor structures can further comprise respective channel layers as well as gate structures and source/drain (S/D) structures alternatively arranged along a channel direction.

The first and second CFET element (or more specifically their transistor structures) can form a CFET cell. The CFET cell can be a base cell, in particular a double row base cell, of the CFET structure. For instance, a base cell of a CFET standard cell can comprise two rows.

For instance, the first and the second row of the CFET structure extend along the channel direction, i.e., perpendicular to a gate track. The shared signal routing structure may extend in the same direction as the rows, i.e., parallel to the rows.

The CFET cell can form a logic cell or a unit cell of the CFET structure (e.g., an inverter or NAND cell). The CFET structure may comprise a plurality of CFET cells.

The CFET element respectively the CFET cell may comprise further transistor structures or other elements, which could respectively be directly above or beneath the first and second transistor structure.

The CFET structure can be a CFET device or a part or component thereof. The CFET device can comprise a plurality of CFET cells.

Notably, in this disclosure the terms "below" and "above", "bottom" and "top", "front(side)" and "back(side)", or similar terms are to be interpreted relative to each other. In particular, these terms describe opposite sides of the CFET structure, or opposite sides of any element of the CFET structure. The terms may describe a relationship of elements (e.g., transistor structures, signal routing lines, power rails, etc.) of the CFET structure along the direction of stacking of the tiers (or levels) of the CFET structure. The stacking direction may thus align with the arrangement of the two tiers (or even more than two tiers) of the CFET structure. That is, the two or more tiers (or levels), which are arranged above each other, are arranged one after the other along a certain direction (the stacking direction).

A transistor structure in this disclosure may be or may comprise a transistor, for example a field effect transistor (FET), or may be or may comprise a more complex semiconductor-based structure, which functions like a transistor. For instance, the semiconductor-based structure may be a nanosheet structure, a fin structure, or a forksheet structure, for example, provided with a gate partly wrapping around or fully wrapping around channel portions (the latter not in case of a forksheet structure). The latter may be a gate-all-around structure.

The transistor structures of the CFET structure of the first aspect may be NMOS and PMOS transistor structures. For instance, the first transistor structure of the first and/or second CFET element may be an NMOS transistor structure and the second transistor structure of the first and/or second CFET element may be a PMOS transistor structure, or vice versa.

The shared signal routing structure can form a vertical connection between the first and the second transistor structure of a CFET element. Alternatively or additionally, the shared signal routing structure can connect the first and/or second transistor structure of the first CFET element to the first and/or second transistor of the second CFET element.

In an embodiment, the shared signal routing structure is arranged centered between the first and the second CFET element.

For instance, the resulting CFET structure has a symmetrical design. This allows for a compact design of the CFET structure and an efficient connection of the signal routing structure to the transistor structures of both CFET elements.

In an embodiment, the first and the second transistor structures of each CFET element comprise at least one respective source and/or drain structure; wherein the shared signal routing structure is electrically connected to a respective source and/or drain structure of the first and/or the second transistor structure.

The source and/or drain structures which are connected to the shared signal routing structure can comprise an extension which electrically contacts the shared signal routing structure.

In an embodiment, the CFET structure further comprises a set of signal routing lines which are arranged above the second transistor structure of the first and the second CFET element, respectively.

For instance, due to the signal routing structure being shared by two adjacent CFET elements, the overall number of these top signal routing lines can be reduced.

In an embodiment, the CFET structure further comprises a set of further signal routing lines which are arranged below the first transistor structure of the first and the second CFET element, respectively.

In an embodiment, the CFET structure further comprises a spacer structure; wherein a first part of the spacer structure is arranged between the shared signal routing structure and the first CFET element; and wherein a second part of the spacer structure is arranged between the shared signal routing structure and the second CFET element. This achieves the advantage that an alignment and processing of the vertical structures (e.g., of the shared signal routing structure) is facilitated.

For instance, the spacer structure comprises vertical spacer layers which are arranged between the shared signal routing structure and the first respectively second CFET element.

In an embodiment, the spacer structure is formed from a dielectric material, in particular silicon dioxide, SiO₂.

In an embodiment, the CFET structure further comprises: a first power routing structure which is arranged on a side of the first CFET element which is opposite to the shared signal routing structure; and/or a second power routing structure which is arranged on a side of the second CFET element which is opposite to the shared signal routing structure. Hereby, opposite to the shared signal routing structure means on an opposite side of the CFET element than the shared signal routing structure.

The first and second power routing structure can be connected to and receive electrical power from a BSPDN. In this way, the respective transistor structures of the CFET elements can be provided with electrical power (e.g., V_{DD} and Vss).

In an embodiment, a third part of the spacer structure is arranged between the first power routing structure and the first CFET element; and/or a fourth part of the spacer structure is arranged between the second power routing structure and the second CFET element. This achieves the advantage that an alignment and processing of the power routing structures is facilitated.

In an embodiment, the first power routing structure and/or the second power routing structure each comprise: a respective shared power rail which can be electrically connected to the first transistor structure and/or the second transistor structure of at least one of the CFET elements.

Each of the shared power rails can in addition be shared between two CFET elements, for instance between one CFET element of the CFET structure and one CFET element of a neighboring CFET structure. The neighboring CFET structure can have the same basic structure as the CFET structure.

For example, a power routing structure respectively power rail can be connected to a first and/or second transistor structure of a CFET element, and to a first and/or second transistor structure of a further CFET element (e.g, of a neighboring CFET structure).

In an embodiment, the first power routing structure and/or the second power routing structure each comprise: a respective first power rail which can be electrically connected to the first transistor structure of at least one of the CFET elements, and/or a second power rail which can be electrically connected to the second transistor structure of at least one of the CFET elements.

Also, each of this first and second power rails can in addition be shared between two CFET elements, for instance between one CFET element of the CFET structure and one CFET element of a neighboring CFET structure.

In case there are two power rails, the second power rail is arranged above the first power rail. The power rails provide electrical power (V_{DD} and/or Vss) to the first and/or second transistor structure.

A second aspect of this disclosure provides a method of fabricating a complementary field effect transistor (CFET) structure. The method comprises: forming a first CFET element which is arranged in a first row of the CFET structure; and forming a second CFET element which is arranged in a second row of the CFET structure, wherein the second row is arranged laterally offset to the first row; wherein the first and the second CFET element each comprise: a first transistor structure, and a second transistor structure which is arranged above the first transistor structure. The method further comprises: forming a shared signal routing structure which is arranged between the first and the second CFET element; wherein the shared signal routing structure is electrically connected to the first and/or the second transistor structure of the first and/or of the second CFET element, respectively.

In an embodiment, the method further comprises: forming a spacer structure between first and the second row; and patterning the spacer structure to define a location of the shared signal routing structure; wherein the shared signal routing structure is subsequently formed at the defined location. This achieves the advantage that an alignment and processing of the vertical structures (e.g., of the shared signal routing structure) is facilitated.

For instance, the signal routing structure is formed by a suitable metal fill technique.

For example, the spacer structure is formed such that a first part of the spacer structure is arranged between the shared signal routing structure and the first CFET element; and a second part of the spacer structure is arranged between the shared signal routing structure and the second CFET element.

In an embodiment, the spacer structure is formed from a dielectric material, in particular silicon dioxide, SiO₂.

In an embodiment, the method further comprises: forming at least one respective source and/or drain structure of the first and the second transistor structures of each CFET element; wherein the shared signal routing structure is electrically connected to a respective source and/or drain structure of the first and/or the second transistor structure.

In an embodiment, the shared signal routing structure is formed before or after the formation of the source and/or drain structures.

For example, all S/D structures or only the S/D structures, which are electrically connected to the shared signal routing structure, are formed subsequent to the formation of the shared signal routing structure.

In an embodiment, the shared signal routing structure is arranged centered between the first and the second CFET element.

In an embodiment, the method further comprises: forming a set of signal routing lines which are arranged above the second transistor structure of the first and the second CFET element, respectively.

In an embodiment, the method further comprises: forming a set of further signal routing lines which are arranged below the first transistor structure of the first and the second CFET element, respectively.

In an embodiment, the method further comprises: forming a first power routing structure which is arranged on a side of the first CFET element which is opposite to the shared signal routing structure; and/or forming a second power routing structure which is arranged on a side of the second CFET element which is opposite to the shared signal routing structure.

In an embodiment, a third part of the spacer structure is arranged between the first power routing structure and the first CFET element; and/or a fourth part of the spacer structure is arranged between the second power routing structure and the second CFET element.

In an embodiment, the first power routing structure and/or the second power routing structure each comprise: a respective shared power rail which can be electrically connected to the first transistor structure and/or the second transistor structure of at least one of the CFET elements.

In an embodiment, the first power routing structure and/or the second power routing structure each comprise: a respective first power rail which can be electrically connected to the first transistor structure of at least one of the CFET elements, and/or a second power rail which can be electrically connected to the second transistor structure of at least one of the CFET elements.

### BRIEF DESCRIPTION OF THE DRAWINGS

The above described aspects and implementations are explained in the following description of embodiments with respect to the enclosed drawings:
- FIG. 1: shows a schematic diagram of a CFET structure according to an embodiment;
- FIG. 2: shows a perspective view of a CFET structure according to an embodiment;
- FIGS. 3A-B: show schematic views of a CFET structure according to an embodiment;
- FIGS. 4A-B: show schematic views of a CFET structure according to an embodiment;
- FIGS. 5A-B: show schematic views of a CFET structure according to an embodiment;
- FIGS. 6A-B: show schematic views of a CFET structure according to an embodiment;
- FIGS. 7A-B: show schematic views of a CFET structure according to an embodiment; and
- FIGS. 8A-D: show steps of a method of fabricating a CFET structure according to an embodiment.

### DETAILED DESCRIPTION OF EMBODIMENTS

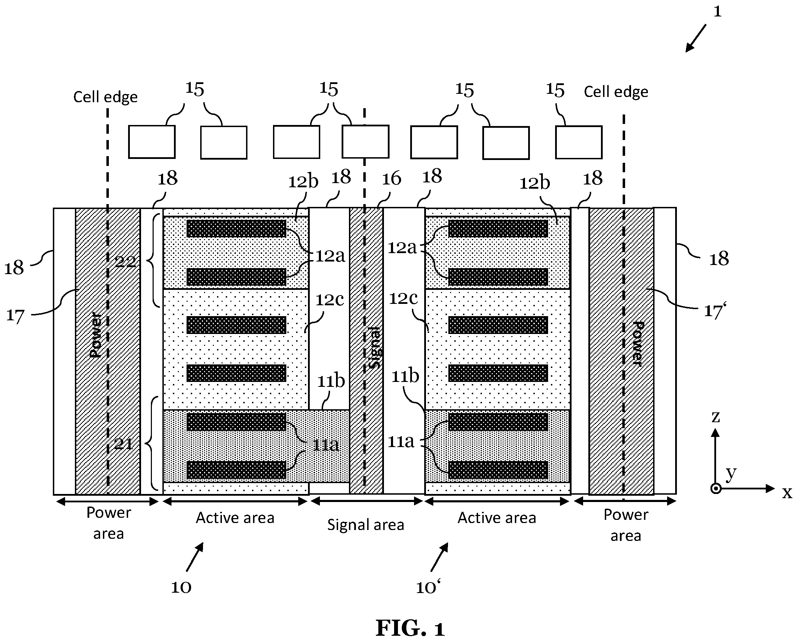

FIG. 1 shows a schematic diagram of a CFET structure 1 according to an embodiment. Thereby, FIG. 1 shows a cross-sectional view through an x-z plane (as indicated by the Cartesian coordinate system), which is perpendicular to a channel direction (y-direction) of the CFET structure 1.

The CFET structure 1 comprises: a first CFET element 10 which is arranged in a first row of the CFET structure 1; and a second CFET element 10'which is arranged in a second row of the CFET structure 1, wherein the second row is arranged laterally offset to the first row; and wherein the first and the second CFET element 10, 10' each comprise: a first transistor structure 21, and a second transistor structure 22 which is arranged above the first transistor structure 21.

The CFET structure 1 further comprises a shared signal routing structure 16 which is arranged between the first and the second CFET element 10, 10'; wherein the shared signal routing structure 16 is electrically connected to the first and/or the second transistor structure 21, 22 of the first and/or of the second CFET element 10, 10', respectively.

Hereby, the relative terms "above" and "below" (or "top" and "bottom") indicate a vertical arrangement along a z-direction, as indicated by the Cartesian coordinate system. This z-direction can be the "stacking direction" of the transistor structures. For instance, the first transistor structure 21 can be a bottom transistor structure and the second transistor structure 22 can be a top transistor structure of the respective CFET elements 10, 10'.

Further hereby, the first and second row of the CFET structure 1 indicate areas of the CFET structure which are arranged laterally offset to each other in x-direction. The rows can extend parallel to the y-direction, i.e., along the channel direction. In FIG. 1, the first and second row are arranged left and right of the central axis of the CFET structure 1 (indicated by the dashed line in the center). Each row may comprise a respective transistor stack (i.e., a stack of first and second transistor structures 21, 22). For instance, the first and second row may refer to the respective areas indicated as "active areas" in FIG. 1. The rows of the CFET structure 1 are not to be confused with the levels (or tiers) of the CFET elements 10, 10' which are formed by the stacking of the transistor structures 21, 22 along the z-direction (according to the Cartesian coordinate system).

The first and the second CFET element 10, 10' (or more specifically their transistor structures 21, 22) can form a CFET cell. The CFET cell can be a base cell, in particular a double row base cell, of the CFET structure. The cell edges of this double row base cell are indicated by dashed lines in FIG. 1.

For instance, the CFET cell is a logic cell or a component of a logic cell. The size of the CFET cell and, in particular, the number of its first and second (or bottom and top) transistor structures 21, 22 can depend on its function.

For example, the first (bottom) transistor structures 21 of the respective CFET elements 10, 10' are arranged in a first tier or level of the CFET structure 1 and the second (top) transistor structures 22 of the respective CFET elements 10, 10' are arranged in a second tier or level of the CFET structure 1, above the first tier.

The transistor structures 21, 22 of the CFET structure may be NMOS and PMOS transistor structures. For instance, the first transistor structure 21 of the first and/or second CFET element 10, 10' may be an NMOS transistor structure and the second transistor structure 22 of the first and/or second CFET element 10, 10' may be a PMOS transistor structure, or vice versa.

Each of the first transistor structure 21 and the second transistor structures can comprise a respective channel structure 11a, 12a, wherein each channel structure 11a, 12a can comprise a number of channel layers, which extend along a y-axis as indicated by the coordinate system. Furthermore, each of the first transistor structure 21 and the second transistor structure 22 can comprise at least two source and/or drain structures 11b, 12b and a gate structure 12c. The source and/or drain structures 11b, 12b can be formed from metal zero (M0) layers, e.g., the top source and/or drain structures 12b from a MDT layer and the bottom source and/or drain structures 11b from a MDB layer (MD stands for metal diffusion). The gate structure 12c can be a common gate structure of the bottom and top transistor structures 21, 22, as shown in FIG. 1.

The shared signal routing structure 16 can form a vertical connection between the first and second transistor structure of a CFET element 10, 10'. Alternatively or additionally, the shared signal routing structure 16 can connect the first and/or second transistor structure 21, 22 of the first CFET element 10 to the first and/or second transistor 21, 22 of the second CFET element 10'.

The shared signal routing structure 16 can comprise a signal line, in particular a vertical signal line. In particular, the shared signal routing structure 16 can comprise a via (e.g., if the connected transistor structures 21, 22 are aligned) or a trench perpendicular to the gates 12c of the CFET elements 10, 10' and parallel (or along) the channel direction.

The shared signal routing structure 16 can be arranged centered between the first and the second CFET element 10, 10'.

For instance, the CFET structure 1 has a symmetrical design with the shared signal routing structure 16, e.g., a trench which extends along an axis of symmetry (y-axis in FIG. 1) of the CFET structure 1. This allows for a compact design of the CFET structure 1 and an efficient connection of the signal routing structure 16 to both CFET elements 10, 10'.

The shared signal routing structure 16 can be electrically connected to a respective source and/or drain structure 11b, 12b of the first and/or the second transistor structure 21, 22. For instance, in this way top and bottom M0A of two different rows (i.e., two different CFET elements 10, 10') and/or of two different transistor devices 21, 22 are electrically connected.

For instance, in the cross-sectional view of FIG. 1, the signal routing structure 16 is connected to a bottom source and/or drain structure 11b of the first (left) CFET element 10. The signal routing structure 16 could be further connected to a top source and/or drain structure 12b of the first CFET element 10 and/or to source and/or drain structures 11b, 12b of the second (right) CFET element 10' which are arranged in a different z-x-plane along the channels 11a, 12a (i.e., in front or behind the source and/or drain structures 11b, 12b in FIG. 1 and thus not visible in the cross-sectional view).

For instance, source and/or drain structures 11b, 12b which are connected to the shared signal routing structure 16 can extend towards the shared signal routing structure 16, i.e., they can comprise an extension which electrically contacts the shared signal routing structure, as shown for the bottom source and/or drain structure 11b of the first CFET element 10 in FIG. 1.

The CFET structure can further comprise a set of signal routing lines 15 (also referred to as: signaling lines) which are arranged above the second transistor structure 22 of the first and the second CFET element 10, 10', respectively.

For example, at least one of the signaling lines 15 can be connected to the signal routing structure 16. The signaling lines 15 can be formed from horizontal metal layers, e.g. metal zero (M0) layers. For instance, FIG. 1 shows a cut along these M0 connections. Individual signal routing lines 15 can further be connected to components of the first and/or second CFET element 10, 10' via further connections (not shown in FIG. 1).

For example, due to the signal routing structure 16 being shared by the two CFET elements 10, 10', the overall number of these top signal routing lines 15 (e.g., formed from M0 or Mint metal layers) can be reduced compared to a CFET structure where each CFET element would have its own signal routing. For example, the number of signal routing lines 15 can be reduced from 8 to 7 (from 4 to 3.5 per row as shown in FIG. 1). In this way, the "cell height" is reduced.

Optionally, the CFET structure 1 can further comprise a spacer structure 18; wherein a first part of the spacer structure 18 is arranged between the shared signal routing structure 16 and the first CFET element 10, and a second part of the spacer structure 18 is arranged between the shared signal routing structure 16 and the second CFET element 10'.

For instance, the spacer structure 18 comprises vertical spacer layers which are arranged between the shared signal routing structure 16 and the first respectively second CFET element 10, 10'. The spacer structure 18 can facilitate an alignment and processing of the vertical structures (e.g., of the shared signal routing structure 16).

The spacer structure 18 or more specifically the vertical layers of the spacer structure 18 can be formed from a dielectric material, such as silicon dioxide (SiO₂).

The spacer structure 18 can electrically isolate the shared signal routing lines from each of the CFET elements 10, 10' in areas, where there is no connection between the two.

Further optionally, the CFET structure 1 can comprise: a first power routing structure 17 that is arranged on a side of the first CFET element 10 which is opposite to the shared signal routing structure 16; and/or a second power routing structure 17' that is arranged on a side of the second CFET element which is opposite to the shared signal routing structure 16.

The first and second power routing structure 17, 17' can be connected to and receive electrical power from a backside power delivery network (BSPDN), which is not shown in FIG. 1. Furthermore, the first power routing structure 17 can be electrically connected to the first CFET element 10, and the second power routing structure 17' can be electrically connected to the second CFET element 10'. In this way, the respective transistor structures of the CFET elements can be provided with electrical power (e.g., V_{DD} and Vss).

For instance, the power routing structures 17, 17' can define a power-area at the edges of the CFET cell, where the devices 21, 22 are connected to V_{DD} or Vss, respectively. At least one of the two V_{DD} or Vss power supplies could be implemented by a backside contact, not shown in FIG. 1.

For example, the first power routing structure 17 and/or the second power routing structure 17' can each comprise a respective shared power rail as shown in FIG. 1. The respective power rails can be electrically connected to the first transistor structure 21 and/or the second transistor structure 22 of the at least one CFET elements 10, 10'. For instance, a power rail can be connected to one of the CFET elements 10, 10' shown in FIG. 1 and to a CFET element of a neighboring CFET structure (not shown in FIG. 1). In this way, the power rail can be shared between two CFET elements.

Furthermore, as shown in FIG. 1, a third part of the spacer structure 18 (e.g., a vertical spacer layer) can be arranged between the first power routing structure 17 and the first CFET element 10, and a fourth part of the spacer structure (e.g., a vertical spacer layer) can be arranged between the second power routing structure 17' and the second CFET element 10'.

Thus, by means of the spacer structure 18 the CFET elements 10, 10' and their components (e.g., gates) can be aligned to the signal routing 16 and power routing structures 17, 17' which facilitates the fabrication of these structures.

A shown in FIG.1, the architecture of the CFET structure 1 can be divided into a respective active area of the first and the second CFET element 10, 10', a shared signal area between the CFET elements 10, 10' and respective power areas on the opposing sides of the CFET elements 10, 10'. This systematic division of the CFET architecture allows for an easier integration scheme with respect of a symmetric CFET design (receiving electrical power from backside power delivery rails or backside vias), the shared side routing 16 and/or the power routing structures 17, 17'. The regions of the CFET structure 1 (power area, active, signal area) can be aligned using the spacer structures 18, delimiting each region of the architecture. In addition, due to the shared signal line 16 in the middle, high aspect-ratio vias can be avoided.

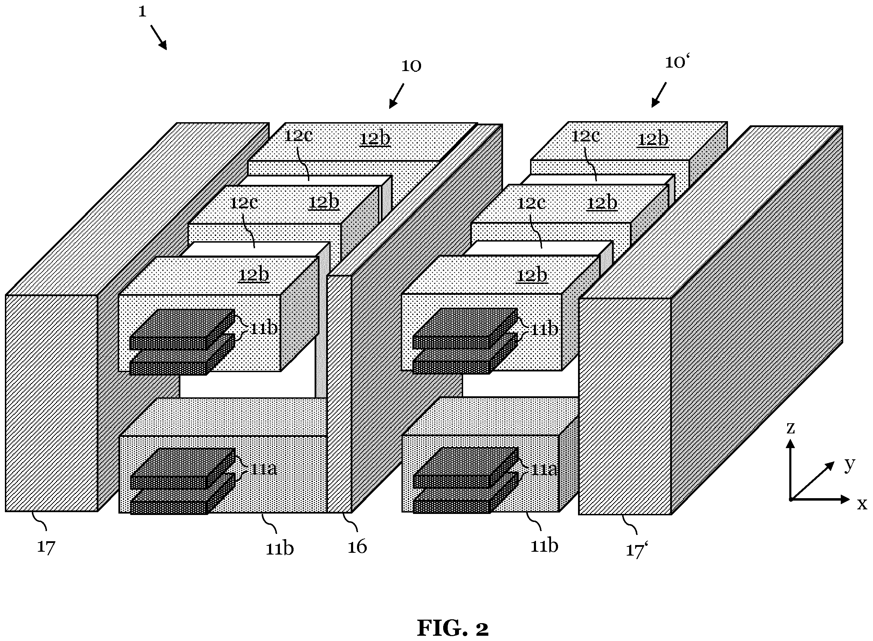

FIGS. 2 to 7B show exemplary embodiments of the CFET structure 1, which build on the CFET structure 1 shown in FIG. 1. Same elements are labelled with the same reference signs. Hereinafter, only the differences between FIG. 1 and FIGS. 2 to 7B are explained.

FIG. 2 shows a perspective view of the CFET structure 1 according to an embodiment. Hereby, the optional spacer structure 18 is not shown for better visibility of the other components.

The channel structures 11a, 12a of the first and second transistor structures 21, 22 can comprise respective channel layers which extend along a channel direction (in FIG. 2 the y-direction). Each transistor structure 21, 22 can comprise a number of source and/or drain (S/D) structures 11b, 12b which are arranged displaced along these channel layers, wherein respective gate structures 12c can be arranged between each two S/D structures 11b, 12b.

In the example shown in FIG. 2, the shared signal routing line 16 electrically connects a bottom S/D structure 11b with a top S/D structure 12b of the first CFET element 10, wherein the connected bottom and top S/D structures 11b, 12b are arranged offset to each other along the channel direction (i.e., not on in the same x-z-plane). However, this particular connection is just an example, and different S/D structures 11b, 12b of the first and/or second CFET element 10, 10' could be electrically connected via the shared signal routing structure 16.

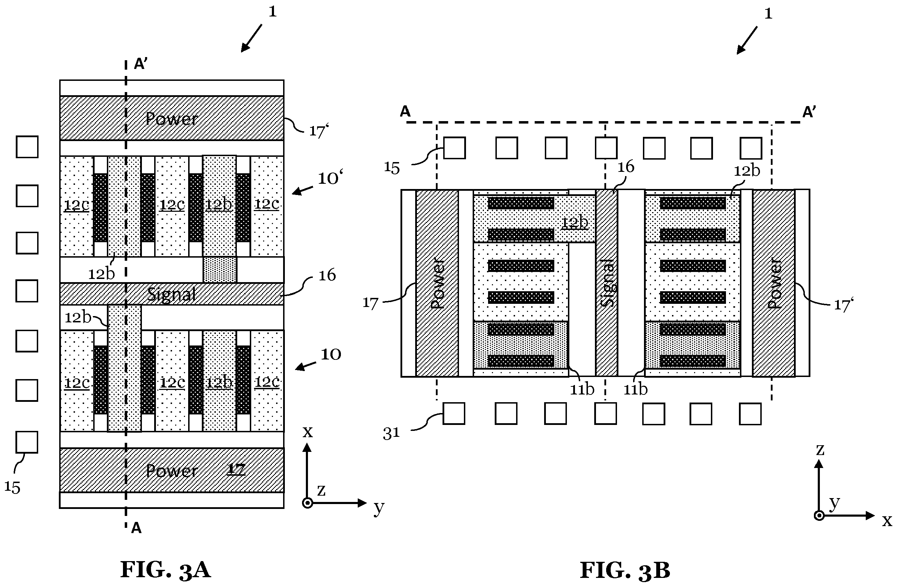

FIGS. 3A and 3B show schematic views of the CFET structure 1 according to an embodiment. Thereby, FIG. 3A shows a top view and FIG. 3B shows a cross-sectional view of the same CFET structure 10, wherein the section line A-A' indicates the position of the cross-section. In FIGS. 3A and 3B, the section line A-A' goes through a top S/D structure 12b of the first CFET element 10 which is connected to the shared signal routing structure 16.

The CFET structure 1 might comprise a set of further signal routing lines 31 which are arranged below the first transistor structure of the first and the second CFET element 10, 10', respectively (only shown in FIG. 3B).

For example, at least one of the further signaling lines 31 can be connected to the signal routing structure 16 and/or to components of the first and/or second CFET element 10, 10' via further connections (not shown in FIG. 3B).

The further signaling lines 31 can be formed from horizontal metal layers, e.g. metal zero (M0) layers. This maybe referred to as (second) backside M0.

These optional further signaling lines 31 can provide increased routing resources. For instance, these back signal routing lines 31 can comprise at least three lines 31 below each CFET element 10, 10' and a further line 31 below the signal area in the center.

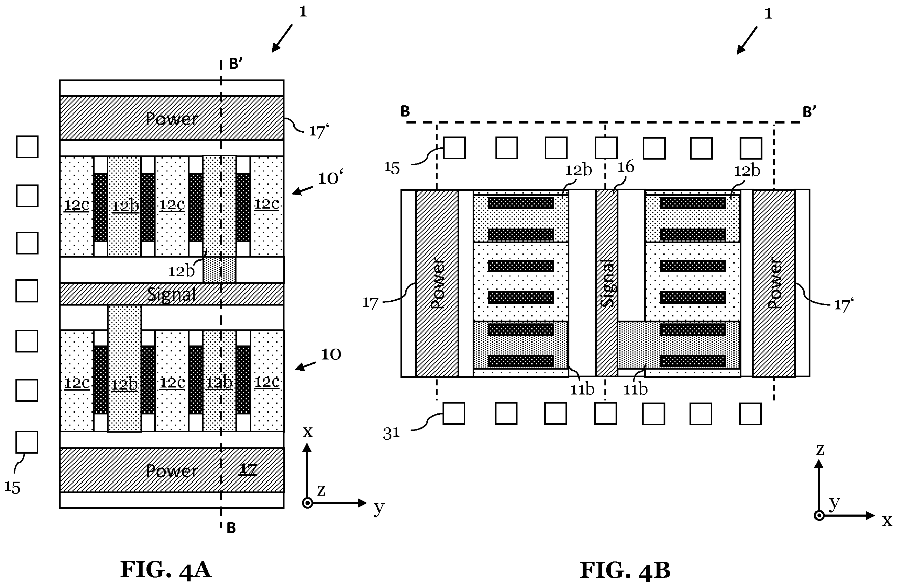

FIGS 4A and 4B show a further top and cross-sectional view of the CFET structure 1 from FIGS. 3A and 3B, wherein the cross-sectional view in FIG. 3B shows a cut along different x-z-plane as indicated by the section line B-B'. The section line B-B' goes through a bottom S/D structure 11b of the second CFET element 10' which is also connected to the shared signal routing structure 16.

Thus, in the example of FIGS. 3A-4B, a respective S/D structure 11b, 12b of each CFET element 10, 10' is electrically connected to the shared signal routing line 16. Alternatively, it is also possible that the shared signal routing line 16 is only used by one side of the structure 1 (i.e., by one CFET element 10, 10').

The number and position of connections between the signal routing structure 16 and the S/D structures 11b, 12b of the first and/or second CFET element 10, 10' depends on the exact function and configuration of the CFET cell which comprises the first and second CFET element.

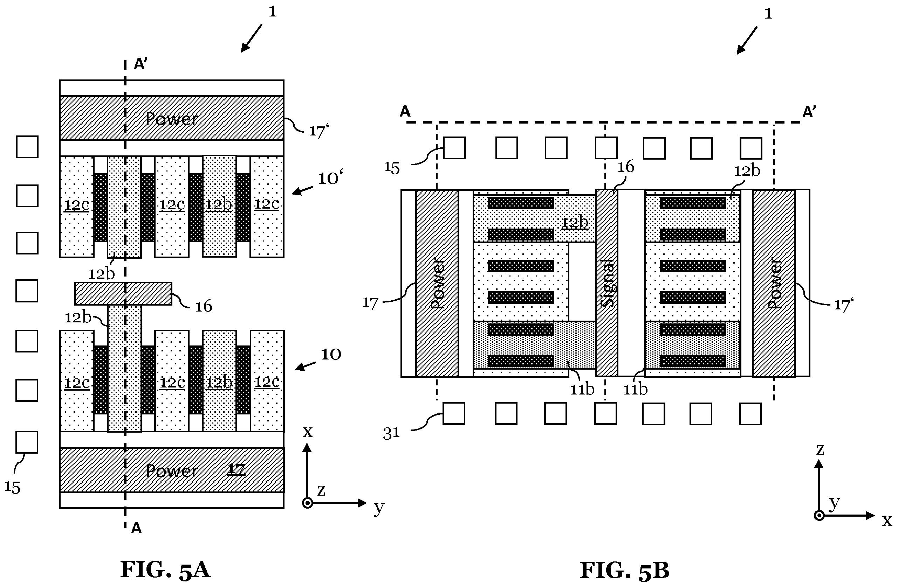

FIGS 5A and 5B show a further exemplary embodiment of the CFET structure 1, wherein a top and a bottom S/D structure 11b, 12b of the first CFET element 10 are connected to the shared signal routing structure 16. The S/D structures 11b, 12b which are connected to the signal routing structure 16 are further arranged on top of each other (i.e., not offset to each other along the channel direction).

In this example, the shared signal routing structure comprises a narrow via which is confined in the channel direction (y-direction) and extends along the z-direction.

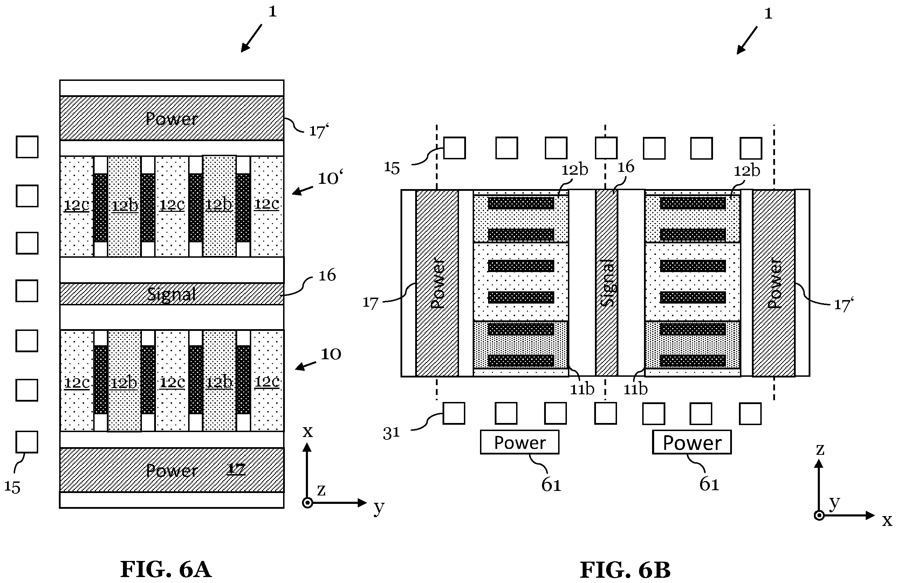

FIGS 6A and 6B show a further exemplary embodiment of the CFET structure 1, wherein a metal layer 61 used for power distribution are arranged below the further signal routing lines 31. The layer 61 carry can provide electrical power to the first and second power routing structures 17, 17'. The layer 61 can be components of a BSPDN or can be electrically connected to a BSPDN.

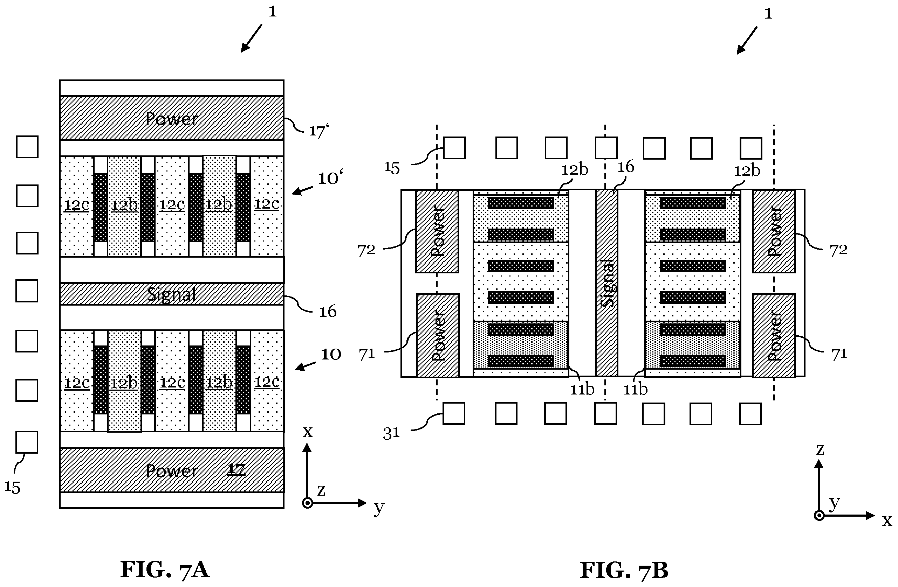

FIGS 7A and 7B show a further exemplary embodiment of the CFET structure 1. In this embodiment, each of the first and the second power routing structure 17, 17' comprises a first and a second power rail 71, 72.

For instance, the first power rail 71 of each power routing structure 17, 17' can be electrically connected to the respective first transistor structure 21, and/or the second power rail 72 of each power routing structure 17, 17' can be electrically connected to the respective second transistor structure 22. This allows for directly connecting the top respectively bottom transistor device 21, 22 to power.

For instance, the second power rail 72, 72' is arranged above the first power rail 71, 71 (in z-direction according to the Cartesian coordinate system). The power rails 71, 71', 72, 72' can provide electrical power (V_{DD} and/or Vss) to the first and/or second transistor structure 21, 22. In this way, each n- or p-device 21, 22 of the CFET elements 10, 10' can have access to a suitable power rail 71, 72.

Each power rail 71, 71', 72, 72' can be shared between one CFET element 10, 10' of the structure 1 shown in FIG. 7B and a CFET element of a neighboring CFET structure (not shown).

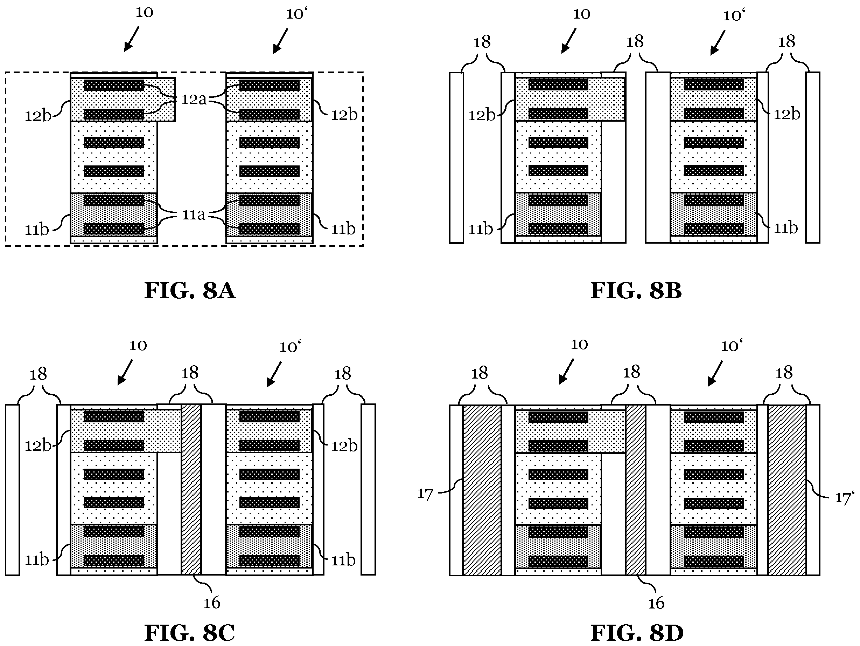

FIGS. 8A-D show steps of a method of fabricating a CFET structure 1 according to an embodiment. Thereby, the sequence of the fabrication steps as shown in FIGS. 8A-D and as discussed in the following is only an example. A different sequence for forming the various elements could be used, depending on the fabrication techniques. The general steps of this method could be used to fabricate any one of the CFET structures 1 as shown in FIGS. 1-7B.

As shown in Fig. 8A, the method comprises the step of: forming the first CFET element 10 which is arranged in the first row of the CFET structure 1; and forming the second CFET element 10' which is arranged in the second row of the CFET structure, wherein the second row is arranged laterally offset to the first row. Thereby, the first and the second CFET element 10, 10' each comprise: a first transistor structure 21, and a second transistor structure 22 which is arranged above the first transistor structure 21.

The step of forming the CFET elements 10, 10' can comprise: forming at least one respective source and/or drain structure 11b, 12b of the first and the second transistor structures 21, 22 of each CFET element 10, 10'. Furthermore, channel structures 11a, 12a and gate structures of the transistor structures 21, 22 can be formed.

As shown in FIG. 8B, the method may comprise the further step of: forming the spacer structure 18 between first and the second row (i.e., between the first and the second CFET element 10, 10'). The spacer structure 18 can be formed from SiO₂.

The spacer structure 18 can be patterned to define the location for the shared signal routing structure 16 and/or to define the locations of the power routing structures 17, 17'.

As shown in FIG. 8C, the shared signal routing structure 16 can subsequently be formed at the defined location between the first and second CFET element 10, 10'. For instance, the shared signal routing structure is formed from a metallic material and is deposited by a suitable metal fill technique.

The shared signal routing structure 16 is electrically connected to the first and/or the second transistor structure 21, 22 of the first and/or of the second CFET element 10, 10', respectively.

This can be realized by an extensions of at least one S/D structure 11b, 12b of the first and/or second CFET element (in FIG. 8C, a top S/D structure 12b of the first CFET element 10).

In optional subsequent steps shown in FIG. 8D, the power routing structures 17, 17' and/or the signaling lines 15 can be formed.

In the example shown in FIGS. 8A-D, the shared signal routing structure 16 is formed after the formation of the source and/or drain structures 11b, 12b. However, it is also possible that the shared signal routing structure 16 is formed first and the S/D structures 11b, 12b or only the S/D structures 11b, 12b, which are electrically connected to the shared signal routing structure 16, are formed subsequent to the formation of the shared signal routing structure 16.

As a consequence of sharing the middle-signal routine via/line 16, process complexity is potentially reduced. In addition, the shared signal routing structure 16 in the middle of the structure 1 can connect to top and bottom devices 21, 22 of the same or different elements 10, 10' which mitigates the need for high aspect-ratio vias which are typical in conventional CFETs and which are difficult to process.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A complementary field effect transistor, CFET, structure (1), comprising:
a first CFET element (10) which is arranged in a first row of the CFET structure (1); and
a second CFET element (10') which is arranged in a second row of the CFET structure (1), wherein the second row is arranged laterally offset to the first row;
wherein the first and the second CFET element (10') each comprise:
- a first transistor structure (21), and
- a second transistor structure (22) which is arranged above the first transistor structure (21);
wherein the CFET structure (1) further comprises a shared signal routing structure (16) which is arranged between the first and the second CFET element (10, 10');
wherein the shared signal routing structure (16) is electrically connected to the first and/or the second transistor structure (21, 22) of the first and/or of the second CFET element (10, 10'), respectively.

2. The CFET structure (1) of claim 1,
wherein the shared signal routing structure (16) is arranged centered between the first and the second CFET element (10, 10').

3. The CFET structure (1) of claim 1 or 2,
wherein the first and the second transistor structures (21, 22) of each CFET element (10, 10') comprise at least one respective source and/or drain structure (11b, 12b);
wherein the shared signal routing structure (16) is electrically connected to a respective source and/or drain structure (11b, 12b) of the first and/or the second transistor structure (21, 22).

4. The CFET structure (1) of any one of the preceding claims, further comprising:
a set of signal routing lines (15) which are arranged above the second transistor structure (22) of the first and the second CFET element (10, 10'), respectively.

5. The CFET structure (1) of any one of the preceding claims, further comprising:
a set of further signal routing lines (31) which are arranged below the first transistor (21) structure of the first and the second CFET element (10, 10'), respectively.

6. The CFET structure (1) of any one of the preceding claims, further comprising:
a spacer structure (18);
wherein a first part of the spacer structure (18) is arranged between the shared signal routing structure (16) and the first CFET element (10); and
wherein a second part of the spacer structure (18) is arranged between the shared signal routing structure (16) and the second CFET element (10').

7. The CFET structure (1) of claim 6,
wherein the spacer structure (18) is formed from a dielectric material, in particular silicon dioxide, SiO₂.

8. The CFET structure (1) of any one of the preceding claims, further comprising:
a first power routing structure (17) which is arranged on a side of the first CFET element (10) which is opposite to the shared signal routing structure (16); and/or
a second power routing structure (17') which is arranged on a side of the second CFET element (10') which is opposite to the shared signal routing structure (16).

9. The CFET structure (1) of claim 6 or 7, and of claim 8,
wherein a third part of the spacer structure (18) is arranged between the first power routing structure (17) and the first CFET element (10); and/or
wherein a fourth part of the spacer structure (18) is arranged between the second power routing structure (17') and the second CFET element (10').

10. The CFET structure (1) of claim 8 or 9,
wherein the first power routing structure (17) and/or the second power routing structure (17') each comprise:
- a respective shared power rail which can be electrically connected to the first transistor structure (21) and/or the second transistor structure (22) of at least one of the CFET elements (10, 10').

11. The CFET structure (1) of claim 8 or 9,
wherein the first power routing structure (17) and/or the second power routing structure (17') each comprise:
- a respective first power rail (71) which can be electrically connected to the first transistor structure (21) of at least one of the CFET elements (10, 10'), and/or
- a respective second power rail (72) which can be electrically connected to the second transistor structure (22) of at least one of the CFET elements (10, 10').

12. A method of fabricating a complementary field effect transistor, CFET, structure (1), comprising:
forming a first CFET element (10) which is arranged in a first row of the CFET structure (1); and
forming a second CFET element (10') which is arranged in a second row of the CFET structure (1), wherein the second row is arranged laterally offset to the first row;
wherein the first and the second CFET element (10, 10') each comprise:
- a first transistor structure (21), and
- a second transistor structure (22) which is arranged above the first transistor structure (21);
forming a shared signal routing structure (16) which is arranged between the first and the second CFET element (10, 10');
wherein the shared signal routing structure (16) is electrically connected to the first and/or the second transistor structure (21, 22) of the first and/or of the second CFET element (10, 10'), respectively.

13. The method of claim 12, further comprising:
forming a spacer structure between first and the second row; and
patterning the spacer structure to define a location of the shared signal routing structure (16);
wherein the shared signal routing structure (16) is subsequently formed at the defined location.

14. The method of claim 12 or 13,
forming at least one respective source and/or drain structure (11b, 12b) of the first and the second transistor structures (21, 22) of each CFET element (10, 10');
wherein the shared signal routing structure (16) is electrically connected to a respective source and/or drain structure (11b, 12b) of the first and/or the second transistor structure (21, 22).

15. The method of claim 13 and 14,
wherein the shared signal routing structure (16) is formed before or after the formation of the source and/or drain structures (11b, 12b).
